# EUROPEAN PATENT SPECIFICATION

(11) **EP 1 523 805 B1**
(45) Date of publication and mention of the grant of the patent: **21.05.2008**
(21) Application number: 03764959.7
(22) Date of filing: 09.07.2003
(51) Int. Cl.: H03G 7/00, H03G 5/00

(54) **CIRCUIT ARRANGEMENT FOR REDUCING THE DYNAMIC RANGE OF AUDIO SIGNALS**
SCHALTUNG ZUM REDUZIEREN DES DYNAMIKBEREICHS VON AUDIOSIGNALEN
CONFIGURATION DE CIRCUIT PERMETTANT DE DIMINUER LA GAMME DYNAMIQUE DES SIGNAUX AUDIO

(30) Priority: 18.07.2002 DE 10232645
(43) Date of publication of application: 20.04.2005
(73) Proprietor: Harman Becker Automotive Systems GmbH, 76307 Karlsbad (DE)
(72) Inventor: SPIELBAUER, Georg, 94377 Steinach (DE); CHRISTOPH, Markus, 94315 Straubing (DE)
(74) Representative: Schmuckermaier, Bernhard
(86) International application number: PCT/EP2003/007442
(87) International publication number: WO 2004/010412

(56) References cited:
- WO-A-02/15395
- WO-A-99/14986
- US-A1- 2001 055 404

## Description

The invention relates to a circuit arrangement for reducing the dynamic range of audio signals.

One problem that occurs frequently in audio systems is that the systems are driven too strongly, and this can lead to undesirable distortion and, in some circumstances, even to damage to the system. Furthermore, it may also be desirable to limit the level of transmission systems in order, for example, to avoid any adverse effect on the hearing of listeners. On the other hand, in an environment filled with noise, it may be desirable to emphasize relatively quiet passages to such an extent above the background noise that they can be perceived by the listener.

Irrespective of whether the aim is to emphasize low levels (for example by means of so-called compounders) or to limit high levels (for example by means of so-called limiters), the outcome in both cases is that the dynamic range of the audio signal is reduced, that is to say the difference between the minimum and maximum levels is reduced. So-called dynamic range compression is advantageous in particular in motor vehicles since in this situation, on the one hand, the background noise level is very high, which can be improved by emphasizing the low levels, and on the other hand the power of the audio system is limited owing to the low supply voltage in motor vehicles, and this can easily lead to distortion at high levels, which can be counteracted by limiting the levels.

WO 02/15395 discloses a method of processing an audio signal in order to overcome background noise extraneous to the audio signal. The method includes comparing a measure of the audio signal in a frequency component of the audio signal to a measure of the noise in a frequency component of the background noise, determining a gain responsive to the comparison and amplifying at least a portion of the audio signal, including at least one frequency segment not included in the frequency component of the audio signal, by the determined gain. The gain generated by a logic unit therefore receives for each frequency component of a voice signal and of the noise signal a power level. The logic unit can thus not take into account the phase values of the frequency components which can lead to some unwanted effects.

One problem that occurs in normal limiters or compandors is that they necessarily always adapt themselves to the highest-energy component within the audio signal, such as bass drums or snare drums, and in the process cause the "volume pumping" which has been known for a long time.

In order to counteract this, US 5,255,324 proposes, for example, that the audio signal be subjected to both narrowband and broadband evaluation, with the process being based initially on the narrowband audio signal and, if this does not result in a satisfactory improvement, broadband evaluation being carried out. US 6,005,953 discloses the provision of a number of frequency bands which are evaluated individually, with the gain of the overall audio signal then being raised or lowered. Although these measures in themselves result in an improvement, it is, however, not sufficient in many cases.

The object of the invention is to specify a circuit arrangement for reducing the dynamic range of audio signals, which is further improved in this regard.

The object is achieved by a circuit arrangement according to Patent Claim 1. Refinements and developments of the idea of the invention are the subject matter of dependent claims.

In detail, the object is achieved by a circuit arrangement having a first transformation device to which an incoming audio signal is supplied and which transforms this audio signal from the time domain to the frequency domain resulting in an input spectrum, a spectral processing device, which is connected downstream from the first transformation device, to receive the input spectrum and use it to produce an output spectrum such that the output spectrum has a narrower dynamic range than the input spectrum, and a transformation device, which is connected downstream from the spectral processing device, is supplied with the output spectrum and transforms this output spectrum from the frequency domain to the time domain, resulting in an output audio signal.

In this case, the transformation device preferably operates using the fast Fourier transformation (FFT) method, and the second transformation device operates using the inverse fast Fourier transformation (IFFT) method. Fast Fourier transformation is characterized by a good ratio of complexity to usefulness. For certain Applications, a Fourier time transformation (FTT) and its inverse function may also be used, for example, instead of fast Fourier transformation.

In order to provide a limiter function, the spectral processing device may attenuate the amplitude in those areas of the spectrum in which the amplitude and/or the spectral range satisfy/satisfies one or more conditions.

One such condition may, for example, be that the amplitude is greater than the first limit value in this spectral range. This results in absolute peaks, that is to say spectral lines of a specific amplitude, being attenuated, for example, such that the relevant spectral line remains below a specific amplitude (attenuation of absolute peaks).

As an alternative or as an additional condition, it is possible to provide for a signal at a specific amplitude and in a specific spectral range not to be audible. The amplitude of the overall signal can then advantageously be reduced by removing from the overall signal spectral components which are in any case not audible. Time and/or spectral masking in specific spectral ranges may be used, for example, as psychoacoustical effects in this context. In this case, it is advantageous to subdivide the spectrum corresponding to the frequency groups of human hearing.

Alternatively or additionally, one condition may also be that the respective amplitude is a maximum or one of the maxima. In this way, the greatest amplitudes are attenuated in a preferred manner (attenuation of relative peaks).

Furthermore, additionally or alternatively, one condition may be given by the position of the respective spectral range in the overall spectrum. This applies in particular to very low or very high tones since these may either be perceived only very weakly by the listener, may not be transmitted (completely) by the acoustic system, or may be corrupted by the room in which they are being listened to.

For dynamic compression, especially for low levels, it is possible to provide for relatively small amplitudes which are greater than a second limit value which corresponds to a specific background noise level and are less than a third limit value which is higher than the second limit value to be emphasized.

The input spectrum and possibly also the output spectrum are preferably complex, so that the phases are also taken into account in the evaluation process.

Finally, in one development of the invention, the first transformation device may be preceded by an advanced initiation device which supplies the incoming audio signal with a delay to the first transformation device, with both transformation devices as well as the processing device being activated when the underlaid incoming audio signal is above a specific amplitude, and with the audio signal being passed on unchanged below the specific amplitude. This allows computation complexity to be saved since overdriving (or underdriving) can be identified in good time, so that the dynamic compression may be activated only when it is required.

The invention will be explained in the following text using exemplary embodiments which are illustrated in the figures of the drawing, in which:
- Figure 1: shows an exemplary embodiment of a circuit arrangement according to the invention, and
- Figure 2: shows a vector diagram in the spectral plane before and after limiting by means of a circuit arrangement as shown in Figure 1.

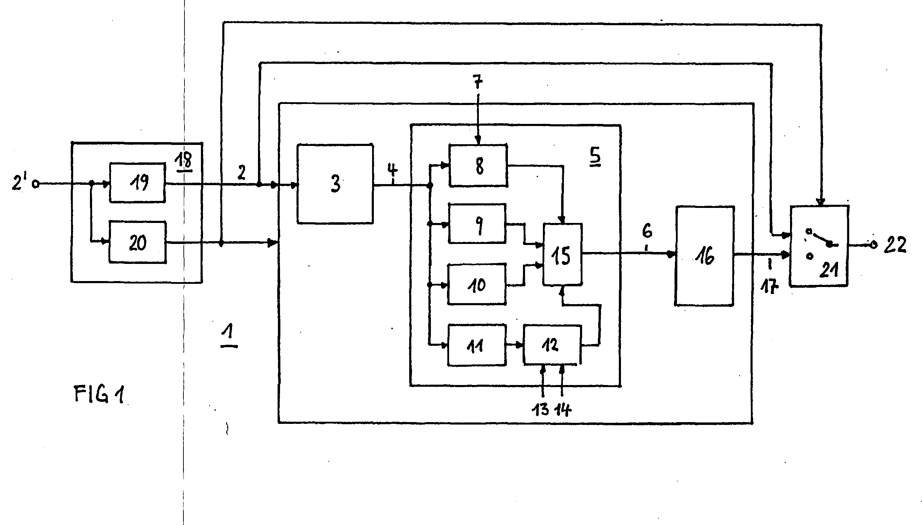

In the exemplary embodiment of a circuit arrangement 1, as shown in Figure 1, for reducing the dynamic range of an incoming audio signal 2, a transformation device 3 is provided, which converts the incoming audio signal 2 to a complex input spectrum 4 by means of fast Fourier transformation (FFT).

The complex input spectrum 4 is then supplied to a spectral processing device 5, which is connected downstream from the transformation device and changes the complex input spectrum 4 so as to produce a complex output spectrum 6 whose resultant dynamic range is restricted in comparison to that of the input spectrum 4. The signal processing in the spectral processing device 5 in this case provides for the individual spectral lines to be evaluated, and to be compared with a limit value 7. A processing unit 8 is provided for this purpose, which detects spectral lines whose amplitude is greater than the limit value 7 and attenuates them to such an extent that they are below the limit value 7.

A further processing unit 9 determines areas in the input spectrum 4 whose amplitude and/or respective spectral range mean/means that they are not psychoacoustically audible. These include, for example, the spectral and time masking of noise. Spectral masking in this case means that a low-frequency tone can completely mask a somewhat higher tone at a lower level, so that the higher tone can no longer be perceived by the listener. A tone which cannot be perceived in this way is identified by the processing unit 9, and is completely removed from the overall signal. In the case of time masking, an acoustic signal at a low level follows a signal at a high level, with the signal which occurs first and is at the high level making the subsequent signal, which is at a low level, inaudible for a certain time. The processing unit 9 also identifies and eliminates the respective spectral range on the basis of this behaviour. The relationships relating to psychoacoustical masking are described, by way of example, in B. Zwicker, "Psychoakustik" [Psychoacoustics], Springer-Verlag 1982, pages 35 to 46 and 93 to 101. The processing unit 9 controls the relationships mentioned therein.

A further processing unit 10 takes account of the spectral position of the individual spectral lines, with very high and very low tones being attenuated to a greater extent than tones in the central range. This results in a loudness function so that high and low frequencies are emphasized when the drive level is low (corresponding to low levels), thus corresponding to the method in which the human hearing operates, which perceives high and low tones at high levels better than at low levels.

If the processing units 8 to 10 are used to provide a limiter function, two further processing units 11 and 12 are provided, which can also generally be used for dynamic compression. The processing unit 11 in this case detects one or more maxima in the input spectrum 4 and attenuates them by a specific amount, with the overall gain, that is to say the amplitudes of all the signals, being emphasized at the same time in the present case. The amplitude peaks are thus reduced, while relatively low levels are correspondingly emphasized at the same time.

In contrast, the processing unit 12 evaluates relatively small amplitudes, which are greater than a third limit value 13 which corresponds to a specific maximum background noise level, but are below a fourth limit value 14, which is higher than the third limit value 13. The two processing units 11 and 12 follow one another in this case, thus resulting, overall, in the dynamic range being tailored "from the top and bottom", and then being further emphasized above the background noise level.

The processing units 8, 9, 10 and 12 are followed by a selection device 15 which selects the processing form (which is predetermined for example as a function of the amplitude distribution and spectral composition of the input spectrum 4 determined by the respective processing unit 8 to 12), or combines a number of processing forms with one another. The selection device 15 then uses this to produce the output spectrum 6 which, in the present case, is likewise complex, but may also be purely real in certain applications.

The output spectrum 6 is supplied to a further transformation device which uses inverse fast Fourier transformation (IFFT) to produce a time signal once again, namely an output audio signal 17.

In the present exemplary embodiment, the transformation device 3 is preceded by an advanced initiation device 18, which supplies the incoming audio signal 2', delayed by means of a delay device 19, as the incoming audio signal 2 to the transformation device 3. In this case, a control device 20 activates or deactivates the circuit arrangement 1 within the delay time, depending on whether the incoming audio signal 2' is or is not greater than a specific limit value. If the specific amplitude limit value is exceeded, then the circuit arrangement 1 is activated during the time in which the signal is passing through the delay device 19, so that the circuit arrangement 1 is ready to operate when the increased amplitude value occurs at the output of the delay device 19.

In this case, the output audio signal 17 is passed to the output 22 to a switching device 21 which is connected downstream from the transformation device 16. Otherwise, the incoming audio signal 2' is passed to the output 22.

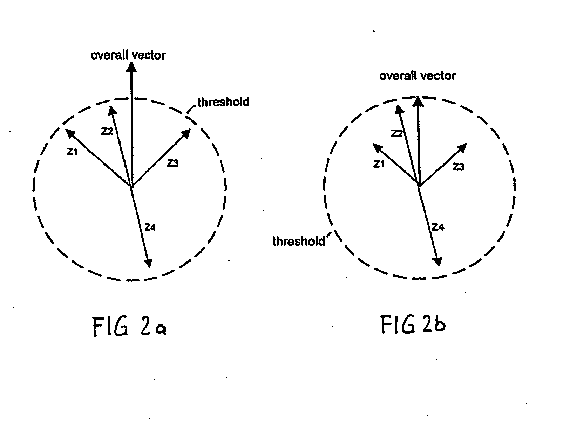

Figure 2 shows the situation before (Figure 2a) and after (Figure 2b) limiting for four spectral lines Z1 to Z4 in two vector diagrams (Figures 2a, 2b), with the phase angle in particular being taken into account in this case. In the case before limiting, it is assumed that all four spectral lines have the sample amplitude, with the spectral lines Z2 and Z4 having opposite phases. This results in an overall vector ZT which is greater than a maximum permissible amplitude value TA. Limiting is now intended to be carried out such that the overall phase does not change. The spectral lines Z2 and Z4 are in this case not used for a reduction process, since they do not contribute to the overall vector. In consequence, the magnitudes of the vectors for the spectral lines Z1 and Z3 are reduced to such an extent that the overall vector ZT is no longer greater than the amplitude threshold value AT.

## Claims

1. Circuit arrangement for reducing the dynamic range of audio signals, having
a first transformation device (3) to which an incoming audio signal (2) is supplied and which transforms this audio signal (2) from the time domain to the frequency domain resulting in an input spectrum (4),
a spectral processing device (5), which is connected downstream from the first transformation device (3), to receive the input spectrum (4) and use it to produce an output spectrum (6) such that the output spectrum (6) has a narrower dynamic range than the input spectrum (4), the spectral processing device (5) adapted for processing spectral lines (Z1, Z2, Z3, Z4) of the input spectrum (4) particularly taking into account the phase angle of the spectral lines (Z1, Z2, Z3, Z4) such that the overall phase of the incoming audio signal (2) does not change, and
a transformation device (16), which is connected downstream from the spectral processing device (5), is supplied with the output spectrum (6) and transforms this output spectrum (6) from the frequency domain to the time domain, resulting in an output audio signal (17).

2. Circuit arrangement according to Claim 1, in which the first transformation device (3) operates using the fast Fourier transformation method, and the second transformation device (16) operates using the inverse fast Fourier transformation method.

3. Circuit arrangement according to Claim 1 or 2, in which the spectral processing device (5) attenuates the amplitude in those areas of the spectrum in which the amplitude and/or the spectral range satisfy/ satisfies one or more conditions.

4. Circuit arrangement according to Claim 3, in which one condition is that the amplitude is greater than a first limit value (7) in one spectral range.

5. Circuit arrangement according to Claim 3 or 4, in which one condition is that a signal at the respective amplitude and in the respective spectral range is not psychoacoustically audible.

6. Circuit arrangement according to one of Claims 3 to 5, in which one condition is that the respective amplitude is a maximum or one of the maxima.

7. Circuit arrangement according to one of Claims 3 to 6, in which one condition is given by the position of the respective spectral range in the overall spectrum.

8. Circuit arrangement according to one of Claims 1 to 7, in which relatively small amplitudes, which are greater than a second limit value (13) which corresponds to a specific basic noise level and are less than a third limit value (14) which is higher than the second limit value (13) are emphasized.

9. The circuit arrangement as claimed in one of Claims 1 to 8, in which the input spectrum is complex.

10. Circuit arrangement according to one of Claims 1 to 9, in which the first transformation device (3) is preceded by an advanced initiation device (18), which supplies the incoming audio signal (2') with a delay to the first transformation device (3), with both transformation devices (3, 16) as well as the processing device (16) being activated when the underlaid incoming audio signal (2') is above a specific amplitude, and with the audio signal (2) being passed on unchanged below the specific amplitude.

## Patentansprüche

1. Schaltungsanordnung zur Reduktion des dynamischen Umfangs eines Audiosignals, aufweisend
eine erste Transformationsanordnung (3), der ein eingehendes Audiosignal (2) zugeführt wird und die dieses Audiosignal (2) vom Zeitbereich in den Frequenzbereich transformiert, wodurch sich ein Eingangsspektrum (4) ergibt,
eine Spektrumsverarbeitungsanordnung (5), die flussabwärts mit der ersten Transformationsanordnung (3) verbunden ist, um das Eingangsspektrum (4) zu empfangen und dieses zu verwenden, um ein Ausgangsspektrum (6) zu erzeugen, so dass das Ausgangsspektrum (6) einen engeren dynamischen Umfang aufweist als das Eingangsspektrum (4), wobei die Spektrumsverarbeitungsanordnung (5) dazu ist, um Spektrallinien (Z1, Z2, Z3, Z4) des Eingangsspektrum (4) unter besonderer Berücksichtigung des Phasenwinkels der Spektrallinien (Z1, Z2, Z3, Z4) zu verarbeiten, so dass sich die Gesamtphase des eingehenden Audiosignals (2) nicht ändert, und
eine Transformationsanordnung (16), die flussabwärts mit der Spektrumsverarbeitungsanordnung (5) verbunden ist, der das Ausgangsspektrum (6) zugeführt wird und die dieses Ausgangsspektrum (6) vom Frequenzbereich in den Zeitbereich transformiert, wodurch sich ein Ausgangsaudiosignal (17) ergibt.

2. Schaltungsanordnung gemäß Anspruch 1, bei der die erste Transformationsanordnung (3) unter Verwendung des Verfahrens der Fast Fourier Transformation arbeitet, und die zweite Transformationsanordnung (16) unter Verwendung des Verfahrens der inversen Fast Fourier Transformation arbeitet.

3. Schaltungsanordnung gemäß Anspruch 1 oder 2, bei der die Spektrumsverarbeitungsanordnung (5) die Amplitude in den Bereichen des Spektrums abschwächt, in denen die Amplitude und/oder der Spektralbereich eine oder mehrere Bedingungen erfüllen.

4. Schaltungsanordnung gemäß Anspruch 3, bei der eine Bedingung ist, dass die Amplitude größer ist als ein erster Grenzwert (7) in einem Spektralbereich.

5. Schaltungsanordnung gemäß Anspruch 3 oder 4, bei der eine Bedingung ist, dass ein Signal mit der entsprechenden Amplitude und in dem entsprechenden Spektralbereich psychoakustisch nicht hörbar ist.

6. Schaltungsanordnung gemäß einem der Ansprüche 3 bis 5, bei der eine Bedingung ist, dass die entsprechende Amplitude ein Maximum oder eines der Maxima ist.

7. Schaltungsanordnung gemäß einem der Ansprüche 3 bis 6, bei der eine Bedingung durch die Position des entsprechenden Spektralbereichs im gesamten Spektrum gegeben ist.

8. Schaltungsanordnung gemäß einem der Ansprüche 1 bis 7, bei der relativ kleine Amplituden, die größer sind als ein zweiter Grenzwert (13), der einem bestimmten Grundrauschpegel entspricht, und kleiner sind als ein dritter Grenzwert (14), der höher ist als der zweite Grenzwert (13), angehoben werden.

9. Schaltungsanordnung gemäß einem der Ansprüche 1 bis 8, bei der das Eingangsspektrum komplex ist.

10. Schaltungsanordnung gemäß einem der Ansprüche 1 bis 9, bei der der ersten Transformationsanordnung (3) eine vorangestellte Initialisierungsvorrichtung (18) vorangeht, die das eingehende Audiosignal (2') mit einer Verzögerung der erste Transformationsanordnung (3) zugeführt, wobei beide Transformationsanordnungen (3, 16) wie auch die Verarbeitungsvorrichtung (16) aktiviert werden, wenn das zugrunde liegende eingehende Audiosignal (2') über einer bestimmten Amplitude liegt, und wobei das Audiosignal (2) unterhalb der bestimmten Amplitude unverändert weiter gegeben wird.

## Revendications

1. Configuration de circuit permettant de diminuer la gamme dynamique des signaux audio, comprenant :
un premier dispositif de transformation (3) sur lequel un signal audio entrant (2) est appliqué et qui transforme ce signal audio (2) du domaine temporel au domaine fréquentiel, par quoi un spectre d'entrée (4) est obtenu,
un dispositif de traitement de spectre (5) qui est raccordé en aval du premier dispositif de transformation (3) pour recevoir le spectre d'entrée (4) et l'utiliser pour produire un spectre de sortie (6) de telle sorte que le spectre de sortie (6) ait une gamme dynamique plus étroite que celle du spectre d'entrée (4), le dispositif de traitement de spectre (5) est adapté pour traiter des lignes spectrales (Z1, Z2, Z3, Z4) du spectre d'entrée (4) en prenant tout particulièrement en compte l'angle de phase des lignes spectrales (Z1, Z2, Z3, Z4) de telle sorte que la phase globale du signal audio entrant (2) ne change pas, et
un dispositif de transformation (16) - qui est raccordé en aval du dispositif de traitement de spectre (5) - reçoit le spectre de sortie (6) et transforme ce spectre de sortie (6) du domaine fréquentiel au domaine temporel, par quoi un signal audio de sortie est obtenu (17).

2. Configuration de circuit selon la revendication 1, dans laquelle le premier dispositif de transformation (3) fonctionne en utilisant la technique de transformée de Fourier rapide, et le second dispositif de transformation (16) fonctionne en utilisant la technique de transformée de Fourier rapide inverse.

3. Configuration de circuit selon la revendication 1 ou 2, dans laquelle le dispositif de traitement de spectre (5) affaiblit l'amplitude dans les zones du spectre dans lesquelles l'amplitude et / ou la plage spectrale satisfait / satisfont une ou plusieurs conditions..

4. Configuration de circuit selon la revendication 3, dans laquelle une des conditions est que l'amplitude soit supérieure à une première valeur limite (7) dans une plage spectrale.

5. Configuration de circuit selon la revendication 3 ou 4, dans laquelle une des conditions est que, un signal à l'amplitude respective et dans la plage spectrale respective, ne soit pas psychoacoustiquement audible.

6. Configuration de circuit selon l'une des revendications 3 à 5, dans laquelle une des conditions est que l'amplitude respective soit un maximum ou l'un parmi des maxima.

7. Configuration de circuit selon l'une des revendications 3 à 6, dans laquelle une des conditions est fournie par la position de la plage spectrale respective dans le spectre global.

8. Configuration de circuit selon l'une des revendications 1 à 7, dans laquelle des amplitudes relativement faibles - qui sont plus élevées qu'une deuxième valeur limite (13) qui correspond à un niveau de bruit de base spécifique, et qui sont moins élevées qu'une troisième valeur limite (14) qui est supérieure à la deuxième valeur limite (13) - sont accentuées.

9. Configuration de circuit selon l'une des revendications 1 à 8, dans laquelle le spectre d'entrée est complexe.

10. Configuration de circuit selon l'une des revendications 1 à 9, dans laquelle le premier dispositif de transformation (3) est précédé par un dispositif d'initiation avancée (18) qui alimente le signal audio entrant (2') avec un retard au premier dispositif de transformation (3), les deux dispositifs de transformation (3, 16) et le dispositif de traitement (16) étant activés quand le signal audio entrant sous-jacent (2') est au dessus d'une amplitude spécifique, le signal audio (2) étant transmis sous sa forme intacte en dessous de l'amplitude spécifique.
